# EUROPÄISCHE PATENTSCHRIFT

(11) **EP 3 013 769 B1**
(45) Veröffentlichungstag und Bekanntmachung des Hinweises auf die Patenterteilung: **20.03.2019**
(21) Anmeldenummer: 14722161.8
(22) Anmeldetag: 30.04.2014
(51) Int. Cl.: C04B 35/01, C04B 35/20, C04B 35/626, C04B 35/043, C04B 35/16, C04B 35/63, C04B 35/66

(54) **FEUERFESTER VERSATZ UND SEINE VERWENDUNG**
REFRACTORY FORMULATION AND USE THEREOF
FORMULATION REFRACTAIRE ET SON UTILISATION

(30) Priorität: 28.06.2013 DE 102013010854
(43) Veröffentlichungstag der Anmeldung: 04.05.2016
(60) Teilanmeldung: 16176221.6
(73) Patentinhaber: Refratechnik Holding GmbH, 85737 Ismaning (DE)
(72) Erfinder: JANSEN, Helge, 37133 Friedland (DE); STEIN, Volker, 37079 Göttingen (DE); SCHEMMEL, Thomas, 40668 Meerbusch (DE)
(74) Vertreter: Patent- und Rechtsanwälte Dr. Solf & Zapf
(86) Internationale Anmeldenummer: PCT/EP2014/058851
(87) Internationale Veröffentlichungsnummer: WO 2014/206602

(56) Entgegenhaltungen:
- EP-A1- 2 883 853
- CN-A- 101 328 070
- CN-A- 101 607 826
- DE-U1-202012 012 495
- JP-A- S 495 407
- US-A- 4 497 901

## Beschreibung

Die Erfindung betrifft eine Versatzfrischmasse enthaltend einen feuerfesten Versatz nach ISO/R 836, DIN 51060, in Form eines trockenen, mineralischen Gemisches, und die Verwendung der Versatzfrischmasse zur Herstellung ungeformter oder geformter feuerfester Erzeugnisse, die in situ in hohem Maße widerstandsfähig sind gegen den Angriff fayalitischer Schlacken (Eisensilikatschlacken) und Sulfaten und beständig gegen Buntmetallschmelzen, insbesondere gegen Kupferschmelze sind. Die Erfindung betrifft zudem einen Formstein aus einer erfindungsgemäßen Versatzfrischmasse.

Fayalitische Schlacken entstehen z. B. bei der Herstellung von Kupfer aus Kupferkies (CuFeS₂). Kupferkies wird geröstet, woraus sogenannter Kupferstein resultiert enthaltend Kupfersulfid (Cu₂S) und Eisenverbindungen, z. B. FeS und Fe₂O₃. Der Kupferstein wird zu Rohkupfer weiterverarbeitet, wobei glutflüssiger Kupferstein unter Luftzufuhr und Zusatz von SiO₂, z. B. in Form von Quarz in einem Konverter behandelt wird. Dabei entsteht eine fayalitische Schlacke, die hauptsächlich das Mineral Fayalit (2FeO·SiO₂) enthält und Rohkupferoxid (Cu₂O).

Man kleidet derzeit die Konverter zur Herstellung von Rohkupfer, z. B. einen Pierce-Smith-Konverter, feuerseitig hauptsächlich mit gebrannten Magnesiachromiterzeugnissen aus (z. B. DE 14 71 231 A1). Diese feuerfesten Erzeugnisse widerstehen aber dabei nur ungenügend dem Angriff von Sulfaten, die aus der Oxidation der Sulfide z. B. in Form von Magnesiumsulfat resultieren. Magnesiachromitsteine haben außerdem nur begrenzte bzw. ungenügende Hochtemperatur-Antiwetting-Eigenschaften und sie weisen einen ungenügenden Penetrationswiderstand gegen heiße Buntmetall- insbesondere Kupferschmelzen auf.

Magnesiachromitsteine werden auch in Schmelzaggregaten für die Erzeugung anderer Nichteisenmetalle (Buntmetalle wie Ni, Pb, Sn, Zn) eingesetzt und ergeben dort gleich gelagerte Probleme.

Die DE 20 2012 012 495 U1 und die WO 2014/016010 A1 offenbaren einen feuerfesten Versatz, insbesondere für die Auskleidung von Buntmetall-Schmelzaggregaten, vorzugsweise für die Auskleidung von Kupferschmelzkonvertern, hauptsächlich enthaltend mindestens 30 Gew.-% eines grobkörnigen Olivinrohstoffs mit Forsteritgehalten von mindestens 70 Gew.-% und Korngrößen von über 0,1 mm, mindestens 35 Gew.-% Magnesia in Mehlform mit Korngrößen von ≤ 1 mm, mindestens 5 Gew.-% Siliciumcarbid in Mehlform mit Korngrößen von ≤ 1 mm, optional maximal 10 Gew.-% einer trockenen feinteiligen Kieselsäure, optional maximal 10 Gew.-% mindestens eines weiteren Zusatzmittels für feuerfeste Erzeugnisse wie Antioxidantien, Rest auf 100 Gew.-% jeweils mindestens einen der anderen Feststoffe. Der Versatz enthält zudem mindestens 2 Gew.-% eines flüssigen Bindemittels in Form eines alkaliarmen, vorzugsweise alkalifreien Kieseslsols, berechnet auf die trockenen Feststoffe.

Aufgabe der Erfindung ist, eine Versatzfrischmasse mit einem feuerfesten mineralischen Versatz für feuerfeste Erzeugnisse und feuerfeste Erzeugnisse daraus zu schaffen, die bei Verwendung in einer feuerfesten Auskleidung gute Antiwetting-Eigenschaften gegen Buntmetallschmelzen, insbesondere gegen Kupferschmelze haben, einen verbesserten Penetrationswiderstand gegen fayalitische Schlacken ergeben und eine bessere Beständigkeit bei einem Sulfatangriff bei Einsatztemperaturen gewährleisten als die auf diesem Feuerfestsektor bisher verwendeten feuerfesten Erzeugnisse.

Diese Aufgabe der Erfindung wird durch eine Versatzfrischmasse bestehend aus Wasser und einem trockenen feuerfesten Versatz gelöst, wobei der trockene Versatz über 90 Gew.-% aus einem Trockenstoffgemisch aus Olivinrohstoff, Magnesiamehl (MgO-Mehl), Siliciumcarbidmehl (SiC-Mehl) und einer trockenen feinteiligen Kieselsäure ausgebildet ist.

Des Weiteren kann ein trockener, erfindungsgemäßer Versatz bis zu 10, insbesondere bis zu 5 Gew.-% für feuerfeste Produkte üblicherweise verwendete Antioxidantien und/oder andere für Feuerfesterzeugnisse üblicherweise verwendete Zusatzstoffe und/oder Zusatzmittel enthalten, wobei aber das Mengenverhältnis der Bestandteile Olivin, MgO, SiC und SiO₂ erhalten bleiben soll.

Der natürlich vorkommende, auf dem Markt erhältliche Olivinrohstoff wird erfindungsgemäß als auf dem Sachgebiet sogenanntes Grobkorngranulat eingesetzt und soll erfindungsgemäß möglichst 100 Gew.-%, mindestens jedoch 70 Gew.-% des Minerals Forsterit aufweisen. Der Rest kann das Mineral Fayalit und/oder können andere bekannte Verunreinigungen des Rohstoffs wie Enstatit und/oder Monticellit und/oder Merwinit sein. Es liegt im Rahmen der Erfindung, einen synthetisch hergestellten, reinen Forsteritwerkstoff allein oder in Kombination mit einem natürlichen Olivinrohstoff zu verwenden. Soweit im Rahmen der Erfindung von Olivinrohstoff die Rede ist, betrifft dies auch den synthetischen Forsteritwerkstoff.

Die verwendete Korngröße des Olivinrghstoffgranulats liegt im Grobkornbereich, also über 0,1 mm, z. B. zwischen >0,1 und 6, insbesondere zwischen 1 und 6 mm, wobei das Granulat z. B. eine Gaußsche Korngrößenverteilung aufweist.

Der Olivinrohstoff wird in Mengen von 3 bis 74 Gew.-%, insbesondere von 21 bis 63,7 Gew.-%, im erfindungsgemäßen Versatzgemisch eingesetzt.

Magnesia wird feinteilig in Form eines Mehls bzw. Pulvers mit Korngrößen 100 Gew.-% ≤ 1 mm verwendet. Als Magnesia wird z. B. Schmelzmagnesia und/oder Sintermagnesia und/oder synthetische totgebrannte oder kaustische Magnesia eingesetzt. (Die Begriffe "Mehl" und "Pulver" werden im Rahmen der Erfindung als gleiche Begriffe mit gleichem Begriffsinhalt verstanden und sind auf dem Sachgebiet bekannt. Man versteht darunter i.d.R. trockene lose Haufwerke aus festen Partikeln ≤ 1 mm Partikelgröße.)

Der MgO-Gehalt der Magnesia soll vorzugsweise > 90 Gew.-%, insbesondere > 95 Gew.-% betragen. Der Rest sind übliche Verunreinigungen wie Silikate und/oder Eisenoxid.

Die MgO-Mehle weisen z. B. ebenfalls eine Gaußsche Korngrößenverteilung auf.

Das MgO-Mehl wird im trockenen Versatzgemisch in Mengen von 25 bis 49, insbesondere von 30 bis 43 Gew.-%, verwendet.

Siliciumcarbid (SiC) ist auf dem Markt als synthetisches Produkt mit hohem Reinheitsgrad und in verschiedenen Körnungen und Korngrößenverteilungen erhältlich und wird erfindungsgemäß in Pulverform bzw. in Mehlform mit Korngrößen 100 Gew.-% ≤ 1 mm verwendet. Die Korngrößenverteilung entspricht vorzugsweise einer Gaußschen Kornverteilung.

Das SiC-Pulver wird z. B. mit einer Reinheit von > 90 Gew.-%, insbesondere > 94 Gew.-% an SiC eingesetzt. Die verwendete Menge im trockenen Versatzgemisch beträgt von 0,9 bis 14, insbesondere von 5 bis 14 Gew.-%.

Die feinteilige, trockene Kieselsäure ist eine Kieselsäure, die mit dem MgO des Magnesiamehls in einem wässrigen Milieu unter Ausbildung von Magnesiumsilikathydratphasen reagiert und z. B. Magnesiumsilikathydratgel und/oder Magnesiumsilikathydratkristallite und/oder Magnesiumsilikathydratkristalle bildet. Der SiO₂-Gehalt der feinteiligen trockenen Kieselsäure liegt vorzugsweise über 90 Gew.-%, insbesondere über 94 Gew.-%. Der erfindungsgemäße Versatz enthält erfindungsgemäß im Gemisch keine flüssigen wasserhaltigen Kieselsäuren wie Kieselsol oder Kieselgel oder Wasserglas od. dgl. Es hat sich in überraschender Weise ergeben, dass trockene feinteilige Kieselsäure bei Zutritt von Wasser zum erfindungsgemäßen Versatz schneller mit dem MgO der Magnesia MSH-Phasen bildet und schneller erhärtet und höhere Kaltdruckfestigkeiten ergibt. Warum das so ist, ist noch nicht geklärt.

Die Kieselsäure ist so feinteilig zu wählen, dass in einer Wasser enthaltenden, erfindungsgemäßen Versatzfrischmasse, die durch Zugabe von Wasser zu einem erfindungsgemäßen trockenen Versatz und Mischen entsteht, eine Reaktion zwischen dem MgO der Magnesiateilchen und Teilchen der Kieselsäure stattfindet und sich Magnesiumsilikathydratphasen - im Folgenden auch MSH-Phasen genannt - z. B. als Gel und/oder Kristallite und/oder Kristalle bilden, die nach Art einer hydraulischen Abbindung eine Verfestigung der wasserhaltigen Masse bewirken. Vorzugsweise wird dafür der Versatz so zusammengestellt, dass sich im wässrigen Milieu, also nach Zugabe von Wasser zum erfindungsgemäßen Versatz, ein pH-Wert über 7, insbesondere über 10 einstellt.

Dementsprechend eignen sich für die Reaktion zu MSH-Phasen z. B. kristalline Quarzmehle einer Feinheit der Quarzteilchen unter 500, insbesondere unter 200 µm.

Des Weiteren sind für die Erfindung als trockene, feinteilige Kieselsäuren besonders geeignet:
- Silikastaub
   Silikastaub ist ein sehr feines, nicht kristallines amorphes SiO₂-Pulver, das in einem Lichtbogenofen entsteht als Nebenprodukt bei der Herstellung von elementarem Silicium oder von Siliciumlegierungen. Es wird z. B. unter dem Handelsnamen Silikastaub oder Mikrosilica auf dem Markt angeboten und weist i.d.R. über 85 Gew.-% SiO₂ auf. Die Partikelgröße des Silikastaubs - auch Silikarauch genannt - liegt i.d.R. unter 1 mm. Die englische Bezeichnung ist "silica fume".
- Pyrogene Kieselsäure
   Pyrogene Kieselsäuren sind sehr reine amorphe SiO₂-Pulver mit SiO₂-Gehalten z. B. bis 99 Gew.-% und mit i.d.R. Teilchengrößen z. B. zwischen 5 und 50 nm und mit hoher spezifischer Oberfläche z. B. zwischen 50 und 600 m²/g. Diese Kieselsäuren werden durch Flammhydrolyse hergestellt. Pyrogene Kieselsäure wird auf dem Markt z. B. unter dem Handelsnamen Aerosil angeboten. Die englische Bezeichnung ist "fumed silica".
- Gefällte Kieselsäure
   Bei der Herstellung von gefällter Kieselsäure auf nassem Wege geht man von Alkalisilikatlösungen aus, aus denen durch Zusatz von Säure sehr reine amorphe Kieselsäuren ausgefällt werden (86 - 88 Gew.-% SiO₂; 10 - 12 Gew.-% Wasser). Die Teilchengröße liegt zwischen 1 und 200 µm und die spezifische Oberfläche zwischen 10 und 500 m²/g. Gehandelt werden gefällte Kieselsäuren z. B. unter dem Handelsnamen "Sipernat" oder "Ultrasil". Trotz des Wassergehalts sind diese Kieselsäuren nicht flüssig, sondern trocken und pulvrig.

Im Rahmen der Erfindung wird mindestens eine der oben genannten Kieselsäuren verwendet. Zweckmäßigerweise werden die Kieselsäuren bezüglich ihrer Reaktionsfähigkeit mit dem MgO des Magnesiamehls ausgewählt und dafür gesorgt, dass die Kieselsäure möglichst vollständig mit MgO beim Erhärten reagiert.

Die feinteilige trockene Kieselsäure wird im trockenen Versatzgemisch von 0,1 bis 10, insbesondere von 0,5 bis 5 Gew.-% verwendet.

Den zu 100 Gew.-% errechneten erfindungsgemäßen oben beschriebenen trockenen Versätzen wird erfindungsgemäß lediglich noch Wasser beigemengt zur Herstellung von erfindungsgemäßen feuerfesten Erzeugnissen.

Erfindungsgemäß werden somit folgende trockene Versätze in Gew.-% zusammengestellt:

| | |
|---|---|
| Olivinrohstoff: | 3 bis 74, insbesondere 24 bis 63,7 |
| Magnesiamehl: | 25 bis 49, insbesondere 30 bis 45 |
| SiC-Mehl: | 0,9 bis 14, insbesondere 5 bis 14 |
| feinteilige Kieselsäure: | 0,1 bis 10, insbesondere 0,5 bis 5 |
| Antioxidantien: | 0 bis 4, insbesondere 0,5 bis 2,5 |
| Zusätzliches feuerfestes Rohstoffgranulat: | 0 bis 4, insbesondere 0,1 bis 3,5 |
| feuerfester Zusatzstoff: | 0 bis 4, insbesondere 0,1 bis 3,5 |
| Zusatzmittel für feuerfeste Erzeugnisse: | 0 bis 2, insbesondere 0,1 bis 1,5 |
| Bindemittel für feuerfeste Erzeugnisse in trockener Form: | 0 bis 10, berechnet auf die Trockensubstanz des Versatzes |

Vorzugsweise ist die Kieselsäure mindestens eine der oben genannten amorphen Kieselsäure.

Die Mengen der Reaktionspartner MgO und SiO₂ in erfindungsgemäßen Versätzen werden so gewählt, dass bei Wasserzusatz von 1 bis 10, insbesondere von 2,5 bis 6 Gew.-%, bezogen auf die Trockensubstanz des Versatzes in einem Zeitraum zwischen 6 und 120, insbesondere zwischen 8 und 12 Stunden im Temperaturbereich von 50 bis 200, insbesondere von 100 bis 150°C Kaltdruckfestigkeiten von 40 bis 160, insbesondere von 60 bis 150 MPa gewährleistbar sind.

Bevorzugt wird erfindungsgemäß vorgesehen, dass das reaktionsfähige MgO des Magnesiamehls mengenmäßig überwiegend zur reaktionsfähigen feinteiligen Kieselsäure vorliegt. Daraus soll resultieren, dass sich nach Wasserzugabe MgO-reiche MSH-Phasen bilden, die bei Einwirkung hoher Temperaturen bis z. B. 1350°C Forsterit (2 MgO ▪ SiO₂) bilden können, der den Forsteritanteil des Olivinrohstoffs erhöht.

Erfindungsgemäß zweckmäßig sind überwiegende Massenverhältnisse MgO zu SiO₂ bis 500. Insbesondere liegt das Verhältnis zwischen 1,2 und 100, vorzugsweise zwischen 1,34 und 50, ganz besonders vorzugsweise zwischen 1,34 und 35.

Aus erfindungsgemäßen Trockenversätzen werden erfindungsgemäße feuerfeste Erzeugnisse nach Zusatz von Wasser hergestellt, wobei eine Mischung mit Wassermengen, bezogen auf die Masse des trockenen Versatzes 1 bis 10 Gew.-%, vorzugsweise 2,5 bis 6,0 Gew.-% beträgt.

Wasserhaltige sogenannte Frischmassen werden erfindungsgemäß mit Wassergehalten z. B. zwischen 1 und 5, insbesondere zwischen 1,5 und 3 Gew.-% mit üblichen Pressverfahren zu geformten Steinrohlingen gepresst. Die geformten Steine lässt man erfindungsgemäß im Temperaturbereich zwischen 15 und 200, vorzugsweise zwischen 50 und 200, insbesondere zwischen 100 und 150°C aushärten und trocknen, wobei MSH-Phasen gebildet werden. Nach dem Aushärten weisen die Steine relativ hohe Festigkeiten auf und sind handhabbar, so dass daraus eine feuerfeste Auskleidung gemauert werden kann. Erfindungsgemäß weisen die Steine Kaltdruckfestigkeiten z. B. zwischen 40 und 100, insbesondere zwischen 60 und 80 MPa, auf.

Es liegt im Rahmen der Erfindung, die geformten und durch Bildung von MSH-Phasen erhärteten bzw. verfestigten und getrockneten Steine keramisch zu brennen, so dass aus den MSH-Phasen vorzugsweise Sinterprodukte, z. B. aus Forsterit entstehen und Sinterbrücken aus z. B. Forsterit zwischen den Olivinkörnern bzw. Olivinteilchen und/oder MgO-Mehlteilchen und/oder SiO₂-Teilchen bilden. Das keramische Brennen wird vorzugsweise im Temperaturbereich von 400 bis 1400, insbesondere von 600 bis 1200°C und während einer Zeitdauer von 1 bis 24, insbesondere von 4 bis 12 Stunden durchgeführt, wobei vorteilhaft ist, in reduzierender Atmosphäre zu brennen.

Für das Pressen von Steinen und die Ausbildung von MSH-Phasen reicht es aus, einem erfindungsgemäßen Versatz von 1 bis 5, insbesondere von 1,5 bis 3 Gew.-% Wasser zuzusetzen. Es liegt im Rahmen der Erfindung, an sich bekannte Fließmittel dem wasserhaltigen Gemenge zuzusetzen, um die Bildsamkeit des Gemenges zu erhöhen. Derartige Fließmittel sind dem Fachmann bekannt. Sie werden i.d.R. in Mengen von 0,01 bis 2, insbesondere von 0,1 bis 1,5 Gew.-% zugesetzt.

Mit höheren Wassergehalten, z. B. von 4 bis 10 Gew.-%, insbesondere von 4 bis 6 Gew.-% werden erfindungsgemäß aus den erfindungsgemäßen trockenen Versätzen bildsame Gießmassen oder Stampfmassen erzeugt und daraus mittels Formgebung in Formen feuerfeste monolithische vorgeformte Fertigteile hergestellt. Die Verfestigung durch MSH-Phasenbildung erfolgt dabei z. B. bei Raumtemperaturen und die Trocknung mit einer entsprechenden erhöhten Temperaturbehandlung. Die Festigkeitsentwicklung der geformten Masse entspricht der der geformten und getemperten Steine. In der Regel liegen die Festigkeiten jedoch sogar höher. Mit dem Begriff "Tempern" soll im Rahmen der vorliegenden Erfindung die Temperaturbehandlung der wasserhaltigen Gemenge im angegebenen Temperaturbereich einschließlich Trocknung gemeint sein.

Ein erfindungsgemäßes Erzeugnis wird zweckmäßig hergestellt, indem aus einem Versatz mit zumindest den Trockenstoffen Olivinrohstoff, Magnesia, SiC und Kieselsäure und Wasser mit geeigneten Mischern ein homogenes Gemenge mit vorgegebener plastischer bzw. bildsamer oder fließfähiger Verarbeitbarkeit erzeugt wird. Diese bildsame oder fließfähige Masse des Gemenges kann vor Ort zur Auskleidung von Schmelzkonvertern verwendet werden. Aus dem Gemenge können - wie bereits beschrieben - aber auch monolithisch geformte Fertigteile oder gepresste Steine erzeugt werden; letztere können ungebrannt oder keramisch gebrannt zur Auskleidung von z. B. Schmelzkonvertern verwendet werden.

Die Erfindung betrifft somit eine Versatzfrischmasse enthaltend einen trockenen Versatz ausschließlich aus oder z. B. hauptsächlich, d. h. z. B. über 90 Gew.-%, insbesondere über 95 Gew.-% aus Olivingranulat, MgO-Mehl und SiC-Mehl und einer feinteiligen, trockenen SiO₂-Komponente, insbesondere in Form von Mikrosilika. Der jeweilige Rest kann z. B. mindestens ein anderes feuerfestes Rohstoffgranulat wie Magnesiachromit, Magnesiumspinelle, Spinelle, Chromoxid, Zirkonoxid, Siliciumnitrid, Zirkon und/oder mindestens ein feuerfester Zusatzstoff wie Magnesiachromit, Magnesiumspinelle, Spinelle, Chromoxid, Zirkonoxid, Siliciumnitrid, Zirkon und/oder mindestens ein Zusatzmittel wie Verflüssiger und/oder Abbinderegulatoren sein.

Die Erfindung betrifft zudem ein Verfahren zur Herstellung eines feuerfesten Erzeugnisses unter Verwendung der erfindungsgemäßen Versatzfrischmasse, wobei der trockene Versatz mit dem Wasser zu der bildsamen wässrigen Versatzfrischmasse gemischt, die Versatzfrischmasse in eine Form eingebracht und zu einem Formkörper geformt und anschließend die Versatzfrischmasse des Formkörpers sich erhärten gelassen und der Formkörper getrocknet wird, insbesondere bis zu einer maximalen Restfeuchte zwischen 0,1 und 4,5 Gew.-%.

Erfindungsgemäß werden aus einem oben angegebenen wasserhaltigen Versatzgemenge durch Pressen gepresste oder ungepresste Formkörper hergestellt und die Formkörper bis auf Restfeuchten vorzugsweise zwischen 0,1 und 2 Gew.-% gebracht oder die Formkörper werden nach einer weiteren Ausführungsform der Erfindung zusätzlich keramisch in einem keramischen Brennofen gebrannt bei Temperaturen zwischen vorzugsweise 400 und 1400, insbesondere zwischen 600 und 1200°C in oxidierender, insbesondere aber in reduzierender Atmosphäre für eine Zeitdauer vorzugsweise zwischen 1 und 24, insbesondere zwischen 4 und 12 Stunden. Die Brennbedingungen werden dabei erfindungsgemäß so gewählt, dass die Bestandteile Olivinrohstoff und SiC während des Brennens möglichst nicht oder nur zu einem geringen Anteil miteinander reagieren, damit diese Bestandteile in situ im Schmelzaggregat, z. B. im Konverter beim Angriff einer Schmelze und/oder Schlacke für die erfindungsgemäße Gewährleistung der Feuerfestigkeit, insbesondere durch Antiwettingwirkung und chemische Beständigkeit gegen Schmelze und Schlackenbestandteile zur Verfügung stehen.

Mit den ungebrannten und gebrannten erfindungsgemäßen Formkörpern können Auskleidungen von Buntmetallschmelzkonvertern erstellt werden, die den bisherigen Auskleidungen bezüglich Infiltrations- und Korrosionswiderstand gegen Buntmetallschmelzen und nichtmetallischen Schmelzen (flüssige Schlacken) der Buntmetallverhüttung überlegen sind. Insbesondere zeigt sich die Überlegenheit der erfindungsgemäßen feuerfesten Erzeugnisse in Kupferschmelzkonvertern, z. B. in einem Pierce-Smith-Konverter (PS-Konverter).

Die ungebrannten gepressten getrockneten Formkörper weisen die folgenden Eigenschaften auf:

| | | |
|---|---|---|
| Rohdichte: | 2,65 | bis 2,80 kg/m³ |
| Kaltdruckfestigkeit: | 60 | bis 100, insbesondere 60 bis 80 MPa |

Die gebrannten Formkörper weisen die folgenden Eigenschaften auf:

| | | |
|---|---|---|
| Rohdichte: | 2,55 | bis 2,75 kg/m³, |
| Kaltdruckfestigkeit: | 30 | bis 80, insbesondere 40 bis 70 MPa. |

Die erfindungsgemäßen Fertigteile weisen z. B. die folgenden Eigenschaften auf:

| | | |
|---|---|---|
| Rohdichte: | 2,55 | bis 2,75 kg/m³, |
| Kaltdruckfestigkeit: | 40 | bis 180, insbesondere 50 bis 150 MPa |

Die erfindungsgemäßen Erzeugnisse eignen sich speziell für den Einsatz in PS-Konvertern für die Kupfererzeugung, sind aber auch mit Vorteilen gegenüber den üblichen feuerfesten Erzeugnissen in anderen Anwendungen, bei denen fayalitische Schlacken und dünnflüssige Buntmetallschmelzen auftreten wie das praktisch in der gesamten Buntmetallindustrie der Fall ist, mit den beschriebenen Vorteilen verwendbar.

Das erfindungsgemäße Konzept beruht darauf, dass basierend auf Olivin-Grobkorn sowie SiC- und MgO-Feinkorn bzw. Mehlkorn sich das Gleichgewicht im Stein zwischen den Reaktionsstoffen aus dem Stein und der Schlacke erst bei Schmelzprozesstemperaturen über 1000°C, z. B. zwischen 1200 und 1350°C einstellt. Bei diesen Temperaturen ist SiC trotz oxidierender Schmelzprozessbedingungen bezüglich Antiwettingwirkung noch voll wirksam. MgO reagiert mit dem entstehenden Oxidationsprodukt des SiC, nämlich dem SiO₂, zu weiterem Forsterit. MgO wird erfindungsgemäß im stöchiometrischen Überschuss zu für eine Reaktion verfügbarem SiO₂ gewählt, um die Bildung von Enstatit, das nicht feuerfest ist, zu vermeiden. Diese Reaktionen in situ während des Schmelzprozesses versiegeln den Stein unmittelbar feuerseitig und behindern die Penetration durch die sehr dünnflüssige Metallschmelze, z. B. Kupferschmelze. Das SiC wirkt zudem als Schlackenbremse. In Kontakt mit den allgegenwärtigen Fayalitschlacken reagiert außerdem das überschüssige MgO zusammen mit dem Forsterit zu Olivin-Mischkristallen. Die Solidus-Temperatur steigt dadurch an, d. h. das Reaktionsprodukt Schlacke-Stein friert auf, d. h. führt zu einem Ansteifen der Schlacke und die Korrosionsreaktion wird gestoppt oder zumindest jedoch stark reduziert.

Nach der Erfindung lässt man somit die gepressten Formkörper, die z. B. einen Wassergehalt zwischen 1 und 5, insbesondere zwischen 1,5 und 3 aufweisen, erhärten, wobei sich die MSH-Phasen bilden, die die Erhärtung bewirken. Die Erhärtungszeit ist temperaturabhängig. Man lässt die gepressten Formkörper zweckmäßigerweise 6 bis 120, insbesondere 24 bis 96 Stunden erhärten und trocknen im Temperaturbereich zwischen 50 und 200, insbesondere zwischen 100 und 150°C bis zu Restfeuchten zwischen 0,1 und 4,5, insbesondere zwischen 0,1 und 2,5 Gew.-% Wassergehalt in einem geeigneten Trocknungsaggregat. Es werden dabei Kaltdruckfestigkeiten zwischen 40 und 100, insbesondere zwischen 60 und 80 MPa erzielt.

Die erfindungsgemäß herstellbaren nicht gepressten, in Formen gegossenen und ggf. vibrierten Frischmassen für monolithische Fertigbauteile weisen Wassergehalte zwischen 4 und 10, insbesondere zwischen 4 und 6 Gew.-% auf. Sie werden in Formen eingebracht und ggf. vibriert. Man lässt sie z. B. an der Luft zwischen 15 und 35°C erhärten und im oben für die gepressten Formkörper angegebenen Temperaturbereich trocknen bis auf Restfeuchten wie bei den gepressten Formkörpern. Dabei erzielt man Kaltdruckfestigkeiten zwischen 40 und 180, insbesondere zwischen 50 und 150 MPa.

Nach einer weiteren, nicht erfindungsgemäßen Ausführungsform wird anstelle von Wasser oder vorzugsweise in Kombination damit mindestens ein an sich bekanntes wasserhaltiges Bindemittel für feuerfeste Erzeugnisse aus der folgenden Gruppe Ligninsulfonat, Magnesiumsulfat und Ethylsilikat verwendet in einer Menge berechnet auf die Trockensubstanz eines Versatzes von z. B. 2 bis 5 Gew.-% für gepresste Erzeugnisse und von z. B. 4 bis 10 Gew.-% für Fertigbauteile und Gießmassen. Der Wasseranteil dieser Bindemittel trägt dabei zur oben beschriebenen MSH-Phasenbildung bei.

Des Weiteren kann im Rahmen einer weiteren nicht erfindungsgemäßen Ausführungsform der Erfindung anstelle von Wasser ein an sich bekanntes Bindemittel für feuerfeste Erzeugnisse aus der Gruppe Pech und/oder Teer und der bekannten Kunstharze wie Phenol-Formaldehydharze verwendet werden jeweils in Mengen von z. B. 2 bis 5 Gew.-% berechnet wie oben. Durch die Anwesenheit von MgO und SiO₂ im Versatz bildet sich der zusätzliche Forsterit erst bei höheren Temperaturen in situ.

Die Erfindung schafft somit folgende neue feuerfeste Versätze und deren Verwendung.

Die Erfindung betrifft eine Versatzfrischmasse gemäß Anspruch 1.

Es liegt im Rahmen der Erfindung, diese erfindungsgemäße Versatzfrischmasse zu kombinieren mit mindestens einem Merkmal der folgenden Merkmale:
- Der trockene Versatz enthält über 90 Gew.-%, insbesondere über 95 Gew.-% eines der folgenden Gemische, vorzugsweise bestehend aus einem der folgenden Gemische:
   21 bis 63,7 Gew.-% des mindestens einen Olivinrohstoffs
   30 bis 43 Gew.-% der mindestens einen Magnesia
   5 bis 14 Gew.-% des mindestens einen Siliciumcarbids
   0,5 bis 5 Gew.-% der mindestens einen Kieselsäure
   0,5 bis 2,5 Gew.-% des mindestens einen Antioxidans
   0,1 bis 3,5 Gew.-% des mindestens einen zusätzlichen feuerfesten Rohstoffgranulats
   0,1 bis 1,5 Gew.-% des mindestens einen Zusatzmittels
   0,1 bis 3,5 Gew.-% des mindestens einen Zusatzstoffs
   0 bis 5 Gew.-% des mindestens einen genannten trockenen Bindemittels
- Der Olivinrohstoff ist ein natürlicher Olivinrohstoff und/oder ein synthetisch hergestellter Forsteritwerkstoff mit Kornbändern des Olivinrohstoffs im sogenannten Grobkornbereich z.B. zwischen > 0,1 und 6, insbesondere zwischen 1 und 6 mm und vorzugsweise einer Gaußschen Kornverteilung.
- Der MgO-Gehalt des Magnesiamehls liegt über 90 Gew.-%, insbesondere über 95 Gew.-% und die Kornverteilung des Magnesiamehls entspricht z. B. einer Gaußschen Kornverteilung.
- Das Siliciumcarbidmehl hat eine Reinheit von über 90 Gew.-%, insbesondere über 94 Gew.-% und weist vorzugsweise eine Gaußsche Kornverteilung auf.
- Die Kieselsäure ist mindestens ein Quarzmehl mit einer Korngröße unter 500 µm und/oder mindestens eine pyrogene Kieselsäure und/oder mindestens eine gefällte Kieselsäure und/oder mindestens ein Kieselrauch.
- Der Versatz weist mindestens ein Zusatzmittel aus der folgenden Gruppe auf:
   Verflüssiger, z. B. Castament (FS20), Hersteller BASF oder Dolapix (FF44), Hersteller Zschimmer und Schwarz
- Der Versatz weist mindestens ein Zuschlagstoffgranulat und/oder einen Zusatzstoff aus der folgenden Gruppe auf:
   Magnesiachromit, Magnesiaspinelle, Spinelle, Chromoxid, Zirkonoxid, Siliciumnitrid, Zirkon
- Die Erfindung betrifft auch ein Verfahren zur Herstellung eines feuerfesten Erzeugnisses unter Verwendung einer oben genannten Versatzfrischmasse, wobei ein trockener Versatz mit Wasser zu der wässrigen Versatzfrischmasse gemischt wird, die Masse in eine Form eingebracht und zu einem Formkörper geformt und anschließend die Masse des Formkörpers sich erhärten gelassen und der Formkörper getrocknet wird, insbesondere bis zu einer maximalen Restfeuchte zwischen 0,1 und 4,5 Gew.-%.
- Für gepresste Erzeugnisse erfolgt das Erhärten und Trocknen bei Temperaturen zwischen 50 und 200°C, insbesondere zwischen 100 und 150°C.
- Für monolithische Fertigbauteile und Gießmassen erfolgt das Erhärten zwischen 15 und 35°C und das Trocknen bei Temperaturen zwischen 50 und 200, insbesondere zwischen 100 und 150°C.
- Beim erfindungsgemäßen Verfahren wird die wasserhaltige Masse zu Formsteinen gepresst und die Formsteine werden erhärtet gelassen und getrocknet, wobei vorzugsweise die Formsteine in einem keramischen Brennofen keramisch gebrannt werden, insbesondere bei Temperaturen zwischen 1.000 und 1.300, vorzugsweise zwischen 1.150 und 1.250°C, in oxidierender Atmosphäre, vorzugsweise in reduzierender Atmosphäre, z. B. mit einer Brenndauer zwischen 4 und 8, insbesondere zwischen 5 und 8 Stunden.
- Beim einem nicht erfindungsgemäßen Verfahren wird der Versatz in Kombination mit Wasser oder anstelle von Wasser mit mindestens einem wasserhaltigen Bindemittel für feuerfeste Erzeugnisse z. B. mit einer Menge von 1 bis 10 Gew.-% zu einer bildsamen Masse gemischt.
- Beim einem nicht erfindungsgemäßen Verfahren wird der Versatz anstelle von Wasser mit mindestens einem Bindemittel aus der Gruppe Pech und/oder Teer und Kunstharze z. B. mit einer Menge von 2 bis 5 Gew.-% zu einer bildsamen Masse gemischt.
- Die Erfindung betrifft auch einen ungebrannten Formkörper, hergestellt nach dem erfindungsgemäßen Verfahren, aufweisend eine Rohdichte zwischen 2,65 und 2,80 kg/m³ und eine Kaltdruckfestigkeit zwischen 60 und 100, insbesondere zwischen 60 und 80 MPa.

## Patentansprüche

1. Versatzfrischmasse für eine Auskleidung von Buntmetall-Schmelzaggregaten bestehend aus
a) einem trockenen Versatz aus mineralischen, feuerfesten Werkstoffen enthaltend über 90 Gew.-% eines Gemisches aus folgenden Bestandteilen:
- 3 bis 74 Gew.-% mindestens eines grobkörnigen Olivinrohstoffs mit Forsteritgehalten von mindestens 70 Gew.-% aufweisend Korngrößen von 100 Gew.-% über 0,1 mm
- 25 bis 49 Gew.-% mindestens einer Magnesia in Mehlform mit Korngrößen von 100 Gew.-% ≤ 1 mm
- 0,9 bis 14 Gew.-% mindestens eines Siliciumcarbids in Mehlform mit Korngrößen von 100 Gew.-% ≤ 1 mm
- 0,1 bis 10 Gew.-% mindestens einer feinteiligen trockenen pulverförmigen Kieselsäure
- 0 bis 4 Gew.-% mindestens eines Antioxidans für feuerfeste Erzeugnisse
- 0 bis 4 Gew.-% mindestens eines zusätzlichen feuerfesten Rohstoffgranulats, wie Magnesiachromit, Magnesiaspinelle, Spinelle, Chromoxid, Zirkonoxid, aufweisend Korngrößen von 100 Gew.-% über 0,1 mm
- 0 bis 2 Gew.-% mindestens eines Zusatzmittels für die Herstellung feuerfester Erzeugnisse aus Versätzen, wie Verflüssiger und/oder Abbinderegulatoren
- 0 bis 4 Gew.-% mindestens eines anderen Zusatzstoffes aus feuerfesten Werkstoffen, wie Magnesiachromit, Magnesiaspinelle, Spinelle, Chromoxid, Zirkonoxid, in Mehlform und
- 0 bis 10 Gew.-% mindestens eines Bindemittels für feuerfeste Erzeugnisse in trockener Form, und
b) Wasser.

2. Versatzfrischmasse nach Anspruch 1,
wobei die Kieselsäure Teilchengrößen ≤ 500 aufweist.

3. Versatzfrischmasse nach Anspruch 1 oder 2,
wobei der trockene Versatz aus den Bestandteilen besteht.

4. Versatzfrischmasse nach einem oder mehreren der vorhergehenden Ansprüche, wobei die Versatzfrischmasse 1 bis 10 Gew.-%, vorzugsweise 2,5 bis 6,0 Gew.-% Wasser, bezogen auf die Trockensubstanz des Versatzes, aufweist.

5. Versatzfrischmasse nach einem oder mehreren der vorhergehenden Ansprüche, wobei der trockene Versatz über 90 Gew.-%, insbesondere über 95 Gew.-% eines der folgenden Gemische enthält, vorzugsweise aus einem der folgenden Gemische besteht:
- 21 bis 63,7 Gew.-% des mindestens einen genannten Olivinrohstoffs
- 30 bis 43 Gew.-% der mindestens einen Magnesia
- 5 bis 14 Gew.-% des mindestens einen Siliciumcarbids
- 0,5 bis 5 Gew.-% der mindestens einen Kieselsäure
- 0,5 bis 2,5 Gew.-%des mindestens einen Antioxidans
- 0,1 bis 3,5 Gew.-% des mindestens einen zusätzlichen feuerfesten Rohstoffgranulats
- 0,1 bis 1,5 Gew.-% des mindestens einen Zusatzmittels
- 0,1 bis 3,5 Gew.-% des mindestens einen Zusatzstoffs
- 0 bis 5 Gew.-% des mindestens einen trockenen Bindemittels.

6. Versatzfrischmasse nach einem oder mehreren der vorhergehenden Ansprüche,
wobei der Olivinrohstoff ein natürlicher Olivinrohstoff und/oder ein synthetisch hergestellter Forsteritwerkstoff ist mit Kornbändern des Olivinrohstoffs im sogenannten Grobkornbereich z. B. zwischen > 0,1 und 6, insbesondere zwischen 1 und 6 mm und vorzugsweise einer Gaußschen Kornverteilung.

7. Versatzfrischmasse nach einem oder mehreren der vorhergehenden Ansprüche,
wobei der MgO-Gehalt des Magnesiamehls über 90 Gew.-%, insbesondere über 95 Gew.-% liegt und die Kornverteilung des Magnesiamehls z. B. einer Gaußschen Kornverteilung entspricht.

8. Versatzfrischmasse nach einem oder mehreren der vorhergehenden Ansprüche,
wobei das Siliciumcarbidmehl eine Reinheit von über 90 Gew.-%, insbesondere über 94 Gew.-% hat und vorzugsweise eine Gaußsche Kornverteilung aufweist.

9. Versatzfrischmasse nach einem oder mehreren der vorhergehenden Ansprüche,
wobei die Kieselsäure mindestens ein Quarzmehl mit einer Korngröße unter 500 µm und/oder mindestens eine pyrogene Kieselsäure und/oder mindestens eine gefällte Kieselsäure und/oder mindestens ein Kieselrauch ist.

10. Versatzfrischmasse nach einem oder mehreren der vorhergehenden Ansprüche,
wobei mindestens ein Verflüssiger als Zusatzmittel enthalten ist.

11. Verwendung einer Versatzfrischmasse nach einem oder mehreren der vorhergehenden Ansprüche für die Auskleidung von Buntmetall-Schmelzaggregaten, insbesondere für die Auskleidung von Kupferschmelzkonvertern.

12. Verfahren zur Herstellung eines feuerfesten Erzeugnisses unter Verwendung einer Versatzfrischmasse nach einem oder mehreren der Ansprüche 1 bis 10,
wobei der trockene Versatz mit dem Wasser zu der bildsamen wässrigen Versatzfrischmasse gemischt, die Versatzfrischmasse in eine Form eingebracht und zu einem Formkörper geformt und anschließend die Versatzfrischmasse des Formkörpers sich erhärten gelassen und der Formkörper getrocknet wird, insbesondere bis zu einer maximalen Restfeuchte zwischen 0,1 und 4,5 Gew.-%.

13. Verfahren nach Anspruch 12,
wobei für gepresste Erzeugnisse das Erhärten und Trocknen bei Temperaturen zwischen 50 und 200°C, insbesondere zwischen 100 und 150°C erfolgt.

14. Verfahren nach Anspruch 12 oder 13,
wobei für monolithische Fertigbauteile und Gießmassen das Erhärten zwischen 15 und 35°C und das Trocknen bei Temperaturen zwischen 50 und 200°C, insbesondere zwischen 100 und 150°C erfolgt.

15. Verfahren nach einem oder mehreren der Ansprüche 12 bis 14,
wobei die wasserhaltige Versatzfrischmasse zu Formsteinen gepresst wird und die Formsteine erhärtet gelassen und getrocknet werden, wobei vorzugsweise die Formsteine in einem keramischen Brennofen keramisch gebrannt werden, insbesondere bei Temperaturen zwischen 1.000 und 1.300°C, vorzugsweise zwischen 1.150 und 1.250°C, in oxidierender Atmosphäre oder in reduzierender Atmosphäre, z. B. mit einer Brenndauer zwischen 4 und 8 Stunden, insbesondere zwischen 5 und 8 Stunden.

16. Formkörper hergestellt aus einer Versatzfrischmasse nach einem der Ansprüche 1 bis 10,
wobei der Formkörper ungebrannt ist und eine Rohdichte zwischen 2,65 und 2,80 kg/m³ und eine Kaltdruckfestigkeit zwischen 60 und 100 MPa aufweist.

## Claims

1. Batch fresh-mass for a lining of non-ferrous heavy metal ("Buntmetall") melting units consisting of
a) a dry batch of mineral, refractory material containing more than 90 wt.-% of a mixture of the following components:
- 3 to 74 wt.-% of at least one coarse-grain olivine raw material having forsterite contents of at least 70 wt.-% and having grain sizes of 100 wt.-% above 0.1 mm
- 25 to 49 wt.-% of at least one magnesia in meal form having grain sizes of 100 wt.-% ≤ 1 mm
- 0.9 to 14 wt.-% of at least one silicon carbide in meal form with grain sizes of 100 wt.-% ≤ 1 mm
- 0.1 to 10 wt.-% of at least one fine-particle dry pulverulent silica
- 0 to 4 wt.-% of at least one antioxidant for refractory products
- 0 to 4 wt.-% of at least one additional refractory raw material granulate, such as magnesia chromite, magnesia spinel, spinel, chromium oxide, zirconia, having grain sizes of 100 wt.-% above 0.1 mm
- 0 to 2 wt.-% of at least one admixture for the production of refractory products from batches, such as liquefiers and/or binding regulators
- 0 to 4 wt.-% of at least one other additive made of refractory materials, in meal form such as magnesia chromite, magnesia spinel, spinel, chromium oxide, zirconia, and
- 0 to 10 wt.-% of at least one binder for refractory products in dry form, and
b) water.

2. Batch fresh-mass according to claim 1,
wherein the silica having particle sizes ≤ 500.

3. Batch fresh-mass according to claim 1 or 2,
wherein the dry batch consisting of the components.

4. Batch fresh-mass according to one or more of the previous claims,
wherein the batch fresh-mass comprises 1 to 10 wt.-%, preferably 2,5 to 6,0 wt. % water, based on the dry substance of the batch.

5. Batch fresh-mass according to one or more of the previous claims,
wherein the dry batch containing more than 90 wt.-%, particularly more than 95 wt.-%, of one of the following mixtures, preferably consisting of one of the following mixtures:
- 21 to 63.7 wt.-% of the at least one said olivine raw material,
- 30 to 43 wt.-% of the at least one magnesia,
- 5 to 14 wt.-% of the at least one silicon carbide,
- 0.5 to 5 wt.-% of the at least one silica,
- 0.5 to 2.5 wt.-% of the at least one antioxidant,
- 0.1 to 3.5 wt.-% of the at least one additional refractory raw material granulate,
- 0.1 to 1.5 wt.-% of the at least one admixture,
- 0.1 to 3.5 wt.-% of the at least one additive,
- 0 to 5 wt.-% of the at least one dry binder.

6. Batch fresh-mass according to one or more of the previous claims,
wherein the olivine raw material is a natural olivine raw material and/or a synthetically produced forsterite material having grain bands of the olivine raw material in what is called the coarse-grain range, for example between > 0.1 and 6, particularly between 1 and 6 mm, and preferably a Gaussian grain distribution.

7. Batch fresh-mass according to one or more of the previous claims,
wherein the MgO content of the magnesia meal is above 90 wt.-%, particularly above 95 wt.-%, and the grain distribution of the magnesia meal corresponds for example to a Gaussian grain distribution.

8. Batch fresh-mass according to one or more of the previous claims,
wherein the silicon carbide meal has a purity of above 90 wt.-%, particularly above 94 wt.-%, and preferably a Gaussian grain distribution.

9. Batch fresh-mass according to one or more of the previous claims,
wherein the silica is at least one quartz meal having a grain size of less than 500 µm and/or at least one pyrogenic silica and/or at least one precipitated silica and/or at least one silica fume.

10. Batch fresh-mass according to one or more of the previous claims,
wherein the batch containing at least one liquefier as an admixture.

11. Use of a batch fresh-mass according to one or more of the previous claims,
for the lining of non-ferrous heavy metal ("Buntmetall") melting units, particularly for the lining of copper melt converters.

12. Method for the production of a refractory product, using a batch fresh-mass according to one or more of claims 1 to 10,
wherein the dry batch is mixed with the water to form the ductile aqueous batch fresh-mass, the batch fresh-mass is introduced into a mold and formed into a molded body and subsequently the batch fresh-mass of the molded body is allowed to harden and the molded body is dried, particularly down to a maximal residual moisture between 0.1 and 4.5 wt.-%.

13. Method according to claim 12,
wherein for pressed products, hardening and drying takes place at temperatures between 50 and 200 °C, particularly between 100 and 150 °C.

14. Method according to claim 12 or 13,
wherein for monolithic prefabricated components and castables, hardening takes place between 15 and 35 °C and drying takes place at temperatures between 50 and 200°C, particularly between 100 and 150 °C.

15. Method according to one or more of claims 12 to 14,
wherein an aqueous batch fresh-mass is compressed into molded bricks and the molded bricks are allowed to harden and are dried, wherein preferably the molded bricks are ceramically fired in a ceramic burning kiln, particularly at temperatures between 1000 and 1300°C, preferably between 1150 and 1250 °C, in an oxidizing atmosphere or in a reducing atmosphere, for example with a firing time between 4 and 8 hours, particularly between 5 and 8 hours.

16. Molded brick made of a batch fresh-mass according to one of claims 1 to 10,
wherein the moulded brick is unfired and comprises a raw density between 2.65 and 2.80 kg/dm³ and a cold compressive strength between 60 and 100 MPa.

## Revendications

1. Masse fraîche de mélange pour un revêtement d'agrégats de fonte de métaux non ferreux composée de
a) un mélange sec de matériaux minéraux réfractaires contenant plus de 90 % en poids d'un mélange des composants suivants :
- 3 à 74 % en poids d'au moins une matière première d'olivine à gros grains avec des teneurs en forstérite d'au moins 70 % en poids présentant des granulométries de 100 % en poids supérieures à 0,1 mm
- 25 à 49 % en poids d'au moins une magnésie sous forme de farine avec des granulométries de 100 % en poids ≤ 1 mm
- 0,9 à 14 % en poids d'au moins un carbure de silicium sous forme de farine avec des granulométries de 100 % en poids ≤ 1 mm
- 0,1 à 10 % en poids d'au moins une silice pulvérulente sèche fine
- 0 à 4 % en poids d'au moins un antioxydant pour produits réfractaires
- 0 à 4 % en poids d'au moins un granulé de matière première réfractaire supplémentaire, tel que la chromite de magnésie, le spinelle de magnésie, le spinelle, l'oxyde de chrome, l'oxyde de zirconium, présentant des granulométries de 100 % en poids supérieures à 0,1 mm
- 0 à 2 % en poids d'au moins un adjuvant pour la fabrication de produits réfractaires de mélanges, tels que des liquéfacteurs et/ou des régulateurs de prise
- 0 à 4 % en poids d'au moins un autre additif de matériaux réfractaires, tel que la chromite de magnésie, le spinelle de magnésie, le spinelle, l'oxyde de chrome, l'oxyde de zirconium, sous forme de farine et
- 0 à 10 % en poids d'au moins un liant pour produits réfractaires sous forme sèche, et
b) de l'eau.

2. Masse fraîche de mélange selon la revendication 1,
dans laquelle la silice présente des tailles de particules ≤ 500.

3. Masse fraîche de mélange selon la revendication 1 ou 2,
dans laquelle le mélange sec se compose des composants.

4. Masse fraîche de mélange selon une ou plusieurs des revendications précédentes, dans laquelle la masse fraîche de mélange présente 1 à 10 % en poids, de préférence 2,5 à 6,0 % en poids d'eau, par rapport à la substance sèche du mélange.

5. Masse fraîche de mélange selon une ou plusieurs des revendications précédentes, dans laquelle le mélange sec contient plus de 90 % en poids, en particulier plus de 95 % en poids d'un des mélanges suivants, de préférence se compose d'un des mélanges suivants :
- 21 à 63,7 % en poids de ladite au moins une matière première d'olivine
- 30 à 43 % en poids de ladite au moins une magnésie
- 5 à 14 % en poids dudit au moins un carbure de silicium
- 0,5 à 5 % en poids de ladite au moins une silice
- 0,5 à 2,5 % en poids dudit au moins un antioxydant
- 0,1 à 3,5 % en poids dudit au moins un granulé de matière première réfractaire supplémentaire
- 0,1 à 1,5 % en poids dudit au moins un adjuvant
- 0,1 à 3,5 % en poids dudit au moins un additif
- 0 à 5 % en poids dudit au moins un liant sec.

6. Masse fraîche de mélange selon une ou plusieurs des revendications précédentes,
dans laquelle la matière première d'olivine est une matière première d'olivine naturelle et/ou un matériau de forstérite fabriqué synthétiquement avec des bandes de grains de la matière première d'olivine dans ladite plage de gros grains, par exemple entre > 0,1 et 6, en particulier entre 1 et 6 mm et de préférence une distribution de Gauss.

7. Masse fraîche de mélange selon une ou plusieurs des revendications précédentes,
dans laquelle la teneur en MgO de la farine de magnésie est supérieure à 90 % en poids, en particulier supérieure à 95 % et la distribution granulométrique de la farine de magnésie correspond par exemple à une distribution de Gauss.

8. Masse fraîche de mélange selon une ou plusieurs des revendications précédentes,
dans laquelle la farine de carbure de silicium présente une pureté de plus de 90 % en poids, en particulier de plus de 94 % en poids et présente de préférence une distribution de Gauss.

9. Masse fraîche de mélange selon une ou plusieurs des revendications précédentes,
dans laquelle la silice est au moins une farine de quartz avec une granulométrie inférieure à 500 µm et/ou au moins une silice pyrogène et/ou au moins un précipité de silice et/ou au moins une fumée de silice.

10. Masse fraîche de mélange selon une ou plusieurs des revendications précédentes,
dans laquelle au moins un liquéfacteur est contenu en tant qu'adjuvant.

11. Utilisation d'une masse fraîche de mélange selon une ou plusieurs des revendications précédentes pour le revêtement d'agrégats de fonte de métaux non ferreux, en particulier pour le revêtement de convertisseurs de fonte de cuivre.

12. Procédé de fabrication d'un produit réfractaire utilisant une masse fraîche de mélange selon une ou plusieurs des revendications 1 à 10,
dans lequel le mélange sec est mélangé avec l'eau pour former la masse fraîche de mélange aqueuse malléable, la masse fraîche de mélange est introduite dans un moule et moulée en un corps moulé et ensuite la masse fraîche de mélange du corps moulé est durcie et le corps moulé est séché, en particulier jusqu'à une humidité résiduelle maximum comprise entre 0,1 et 4,5 % en poids.

13. Procédé selon la revendication 12,
dans lequel pour les produits pressés, le durcissement et le séchage se fait à des températures comprises entre 50 et 200 °C, en particulier entre 100 et 150 °C.

14. Procédé selon la revendication 12 ou 13,
dans lequel pour les éléments préfabriqués monolithiques et les masses coulées, le durcissement se fait entre 15 et 35 °C et le séchage se fait à des températures comprises entre 50 et 200 °C, en particulier entre 100 et 150 °C.

15. Procédé selon une ou plusieurs des revendications 12 à 14,
dans lequel la masse fraîche de mélange contenant de l'eau est pressée en briques et les briques sont durcies et séchées, dans lequel de préférence les briques sont cuites par cuisson céramique dans un four céramique, en particulier à des températures comprises entre 1 000 et 1 300 °C, de préférence entre 1 150 et 1 250 °C, sous atmosphère oxydante ou sous atmosphère réductrice, par exemple avec une durée de combustion comprise entre 4 et 8 heures, en particulier entre 5 et 8 heures.

16. Corps moulé fabriqué en une masse fraîche de mélange selon l'une quelconque des revendications 1 à 10,
dans lequel le corps moulé n'est pas cuit et présente une densité brute comprise entre 2,65 et 2,80 kg/m³ et une résistance à l'écrasement à froid comprise entre 60 et 100 MPa.
